# EUROPÄISCHE PATENTSCHRIFT

(11) **EP 0 538 658 B1**
(45) Veröffentlichungstag und Bekanntmachung des Hinweises auf die Patenterteilung: **16.07.1997**
(21) Anmeldenummer: 92116827.4
(22) Anmeldetag: 01.10.1992
(51) Int. Cl.: G01R 15/20

(54) **Stromsensor mit integrierter Hallschaltung**
Current sensor with integrated Hall effect device
Capteur de courant avec sonde à effet Hall incorporée

(30) Priorität: 21.10.1991 DE 9113081 U
(43) Veröffentlichungstag der Anmeldung: 28.04.1993
(73) Patentinhaber: SIEMENS AKTIENGESELLSCHAFT, 80333 München (DE)
(72) Erfinder: Hölzlein, Karlheinz, Dr., W-8552 Höchstadt (DE); Ossowicki, Peter, Dipl.-Ing., W-8450 Amberg (DE); Breimesser, Fritz, Dipl.-Ing., W-8500 Nürnberg 20 (DE); Jähne, Hans-Joachim, Dr., W-8450 Amberg (DE)

(56) Entgegenhaltungen:
- FR-A- 2 312 844
- US-A- 4 488 112
- IEEE TRANSACTIONS ON INDUSTRY APPLICATIONS Bd. 1A-11, Nr. 4, August 1975, NEW YORK US Seiten 457 - 464 YAUCH 'A DIFFERENTIAL CURRENT METERING...'
- SIEMENS ZEITSCHRIFT Bd. 49, Nr. 3, 1975, ERLANGEN DE Seiten 165 - 170 MEYER "INTEGRATION ELEKTRONISCHER BAUELEMENTE..."

## Beschreibung

Die Erfindung bezieht sich auf einen Stromsensor mit einer integrierten Hallschaltung, die von einer aus zwei in Spulenachsrichtung hintereinanderliegenden, elektrisch miteinander verbundenen Spulenhälften gebildeten stromdurchflossenen Spule beeinflußbar ist, wobei zwischen den Spulenhalften die integrierte Hallschaltung vertikal zur Spulenachsrichtung empfindlich eingefügt ist.

Ein gattungsgemäßer Stromsensor ist aus der Veröffentlichung IEEE Transactions on Industry Applications, Bd. 1A-11, Nr. 4, 1975, Seiten 457 bis 464, bekannt. Es handelt sich hier um ein Kompensationsverfahren, bei dem der magnetische Fluß in einem magnetischen Eisenkern durch ein Gegenfeld einer mit Strom beaufschlagten Spule kompensiert wird. Die Spule besteht hier aus den zwei in Reihe geschalteten Spulenhalften, wobei zwischen den beiden Spulenhalften in einem Luftspalt des magnetischen Eisenkerns ein Hallsensor zur Messung des resultierenden magnetischen Flusses eingesetzt ist, der auf Null geregelt wird.

Aus der FR-A-2 312 844 ist ein elektronischer Meßtransformator bekannt, bei dem - wie zuvor beschrieben - ebenfalls das Kompensationsverfahren zur Anwendung kommt. Der Hallsensor ist hier in einer Tasche untergebracht, die in einem Luftspalt eines magnetischen Eisenkerns durch einen Spulenkörper gebildet ist. Auf dem Spulenkörper sind zwei nicht miteinander verbundene Spulen aufgewickelt.

Der Erfindung liegt die Aufgabe zugrunde, einen Stromsensor der obengenannten Art mit einem einfachen Aufbau zu schaffen, der auf einfache Weise auch in normalen Leistungsschaltern bzw. Motorschutzschaltern als Stromsensor Verwendung finden kann und bei dem Spannungsverschleppungen vermieden werden. Dies wird beim Stromsensor der obengenannten Art auf einfache Weise mit den Merkmalen des Anspruchs 1 erreicht. Um diese Spannungsverschleppungen zwischen der integrierten Hallschaltung und der stromdurchflossenen Spulenhälfte zu vermeiden, ist ein gemeinsamer Spulenkörper für beide Spulenhälften vorgesehen, der zwischen den Spulenhälften eine Tasche zur Aufnahme der integrierten Hallschaltung aufweist. Wenn auf serienmäßige Teile zurückgegriffen werden soll, ist es vorteilhaft, wenn zwei identische, auf je einen Spulenkörper gewickelte Spulenhälften vorgesehen sind, die an den der integrierten Hallschaltung abgewandten Enden mit einem Rückschlußeisen versehen sind. Der Spannungsabstand kann noch weiter vergrößert werden, wenn der Spulenkörper drei rechteckförmige Flansche aufweist und die Tasche im mittleren Flansch vorgesehen ist und wenn die Spulenanschlüsse an der der Taschenöffnung abgewandten Seite herausgeführt sind. Um auch eventuell zusätzliche Schaltungen oder Verstärker auf einfache Weise anordnen zu können, ist es von Vorteil, wenn die Taschenöffnung mit einer Leiterplatte mit Beschaltung abgeschlossen ist, an der die Anschlüsse für die integrierte Hallschaltung angeschlossen sind. Um auch nach außen hin eine einwandfreie Trennung zwischen Anschlüssen für das nach außen gehende Spannungspotential und den Spulenanschlüssen zu schaffen, ist es von Vorteil, wenn die Anschlüsse für die integrierte Hallschaltung an dem einen äußeren Flansch und die Anschlüsse für die Spule an dem anderen äußeren Flansch vorgesehen sind. Um die Sensoren auf einfache Weise mit einem dreipoligen Leistungsschalter koppeln zu können, ist es weiterhin von Vorteil, wenn drei Stromsensoren als Einheit mit einem Gehäuse zum Ansetzen an einen Leistungsschalter zusammengefaßt sind. Durch das kontinuierliche Stromsignal ergibt sich weiterhin die Möglichkeit, daß der Stromsensor über einen Anpassungsbaustein und ein übergeordnetes Bussystem mit einem Rechnersystem in Verbindung steht.

Anhand der Zeichnung wird ein Ausführungsbeispiel gemäß der Erfindung beschrieben.

Es zeigen:
- FIG 1: den prinzipiellen Aufbau des Stromsensors,
- FIG 2: eine vorteilhafte Aufbauform des Stromsensors,
- FIG 3: einen Aufbau für einen dreipolig ausgeführten Stromsensor, der in
- FIG 4: als Baustein mit einem Leistungsschalter koppelbar ist,
- FIG 5: eine mögliche Einfügung des Stromsensors in ein Konzept eines elektronischen Motorschutzschalters mit Magnetauslösern und einem Ausschaltantrieb.

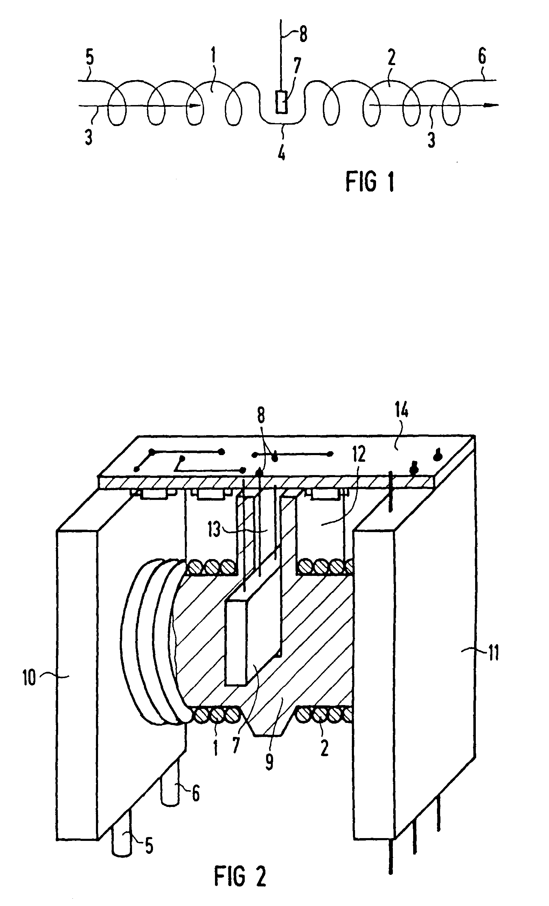

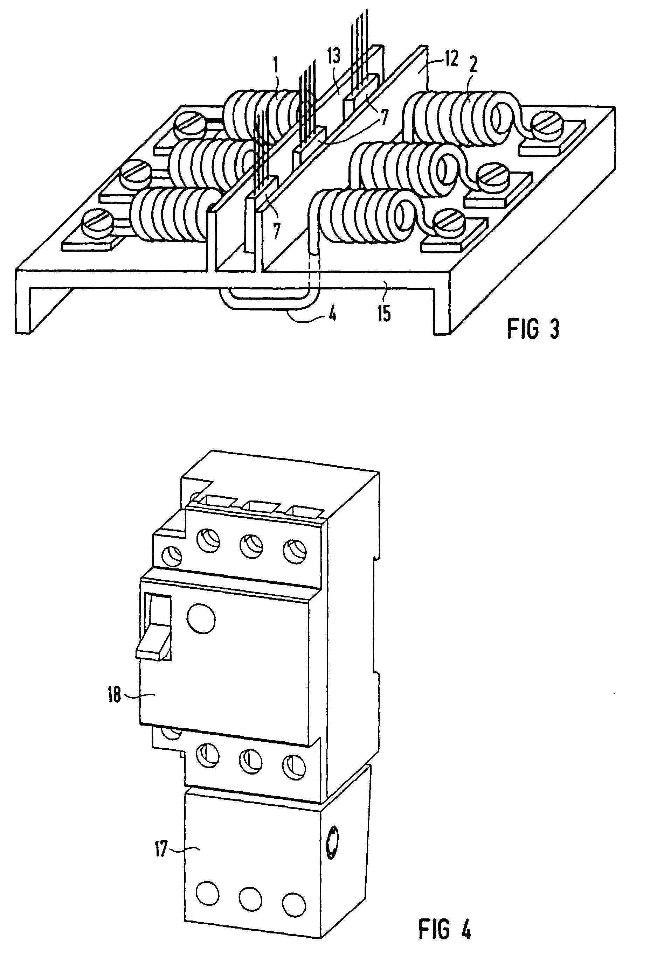

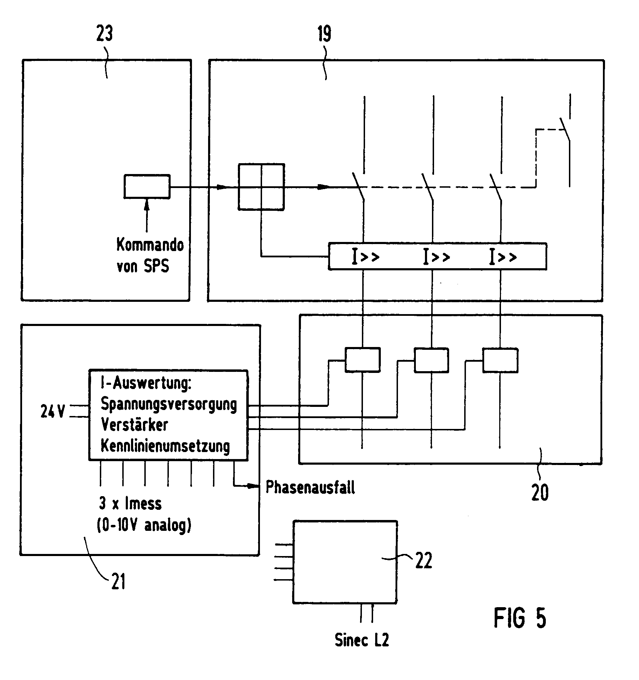

Die Prinzipdarstellung in FIG 1 stellt zwei Spulenhälften 1, 2 dar, die in Achsrichtung durch die Pfeile 3 angedeutet hintereinanderliegen und über eine Verbindungsleitung 4 elektrisch leitend miteinander verbunden sind. Der Spuleneingang ist mit 5 und der Spulenausgang mit 6 bezeichnet. Zwischen den beiden Spulenhälften 1, 2 ist vertikal empfindlich eine integrierte Hallschaltung Hall (IC) 7 mit den Anschlüssen 8 eingefügt. Nach dem konstruktiven Ausführungsbeispiel nach FIG 2 sind die Spulenhälften 1, 2 auf einen gemeinsamen Spulenkörper 9 aufgewickelt. Der Spulenkörper 9 besitzt zwei äußere Flansche 10, 11 und einen mittleren Flansch 12, in dem eine Tasche 13 zum Einfügen der integrierten Hallschaltung 7 vorhanden ist. Die Flansche 11, 10 können Rechteckform aufweisen, so daß auf der einen Seite eine Leiterplatte 14 mit entsprechender Beschaltung aufgebaut werden kann, an der die Anschlüsse 8 der integrierten Hallschaltung angeschlossen werden können. Die Anschlüsse für die Spulen 5, 6 sind im Ausführungsbeispiel nach FIG 2 im Flansch 10 an der der Leiterplatte 14 gegenüberliegenden Seite herausgeführt. Die Anschlüsse für die Leiterplatte 14 und damit indirekt für die integrierte Hallschaltung 7 sind an der der Leiterplatte gegenüberliegenden Seite des Flansches 11 herausgeführt. Durch den mittleren Flansch 12, der auch nur auf der Taschenseite vorhanden sein kann, ist eine gute Spannungsfestigkeit zwischen der Wicklung und der integrierten Hallschaltung erreichbar. Die FIG 3 zeigt eine Ausführung mit drei Stromsensoren auf einem Anschluß-Isolierstoffteil 15. Hier sind Trennwände 16 angeformt, zwischen denen die integrierten Hallschaltungen 7 eingefügt sind. Nach FIG 4 ist der Stromsensor nach FIG 3 in einem Gehäuse 17 angeordnet, das als Anbaueinheit zu einem Leistungsschalter 18 ausgebildet ist. Die FIG 5 zeigt ein Konzept, wie ein elektronischer Motorschutzschalter mit Magnetauslösern und einem Ein/Ausschaltantrieb mit den Stromsensoren zusammenwirken kann. Das Teil 19 dieses Konzeptes stellt den Leistungsschalter mit der Mechanik an sich und den normalen Kurzschlußauslösern dar. Der Teil 20 mit den drei Sensoren dient der Stromerfassung. Die Auswertungsleitungen führen zu einer Auswerteeinheit 21, in der auch die Spannungsversorgung, die Verstärkung bzw. die Kennlinienumsetzung vorgenommen werden kann. In einer derartigen Auswerteschaltung kann auch der Phasenausfall bei dreipoligen Systemen überwacht werden. Anstelle der Auswerteeinheit bzw. zusätzlich kann ein Profi-Bus Interface 22 vorgesehen werden. Die Beeinflussung des Leistungsschalters, d.h. des Teiles 19 erfolgt über entsprechende Signale aus der Auswerteeinheit 21 bzw. von einer speicherprogrammierbaren Steuerung über den Kommandobaustein 23, beispielsweise einem Schrittantrieb.

## Patentansprüche

1. Stromsensor mit einer integrierten Hallschaltung (7), die von einer aus zwei in Spulenachsrichtung hintereinanderliegenden, elektrisch miteinander verbundenen Spulenhalften (1,2) gebildeten stromdurchflossenen Spule beeinflußbar ist, wobei zwischen den Spulenhälften (1,2) die integrierte Hallschaltung (7) vertikal zur Spulenachsrichtung empfindlich eingefügt ist, **dadurch gekennzeichnet**, daß ein gemeinsamer Spulenkörper (9) für beide Spulenhalften (1,2) vorgesehen ist, der zwischen den Spulenhalften eine Tasche (13) zur Aufnahme der integrierten Hallschaltung (7) aufweist.

2. Stromsensor nach Anspruch 1, **dadurch gekennzeichnet**, daß zwei identische, auf je einen Spulenkörper gewickelte Spulenhalften (1,2) vorgesehen sind, die an den der integrierten Hallschaltung (7) abgewandten Enden mit einem Rückschlußeisen versehen sind.

3. Stormsensor nach Anspruch 1 oder 2, **dadurch gekennzeichnet**, daß der Spulenkörper (9) drei rechteckförmige Flansche (10,11,12) aufweist und die Tasche (13) im mittleren Flansch (12) vorgesehen ist und daß die Spulenanschlüsse (5,6) an der der Taschenöffnung abgewandten Seite herausgeführt sind.

4. Stromsensor nach Anspruch 3, **dadurch gekennzeichnet**, daß die Taschenöffnung mit einer Leiterplatte (14) mit Beschaltung abgeschlossen ist, an der die Anschlüsse (8) für die integrierte Hallschaltung (7) angeschlossen sind.

5. Stromsensor nach Anspruch 3 und 4, **dadurch gekennzeichnet**, daß die Anschlüsse (8) für die integrierte Hallschaltung (7) an dem einen äußeren Flansch (11) und die Anschlüsse (5,6) für die Spulenhälften (1,2) an dem anderen äußeren Flansch (10) vorgesehen sind.

6. Stromsensor nach einem der vorhergehenden Ansprüche, **dadurch gekennzeichnet**, daß der Stromsensor Teil eines Leistungsschalters (18) ist.

7. Stromsensor nach einem der vorhergehenden Ansprüche, **dadurch gekennzeichnet**, daß drei Stromsensoren als Einheit mit einem Gehäuse (17) zum Ansetzen an einen Leistungsschalter (18) zusammengefaßt sind.

8. Stromsensor nach einem der vorhergehenden Ansprüche, **dadurch gekennzeichnet**, daß der Stromsensor über einen Anpassungsbaustein (21,22) und ein übergeordnetes Bussystem mit einem Rechnersystem in Verbindung steht.

## Claims

1. Current sensor having an integrated Hall circuit (7), which can be influenced by a current-carrying coil which is formed by two half-coils (1, 2), which are electrically connected to each other and lie one behind the other in the axial direction of the coil, wherein between the half-coils (1, 2), the integrated Hall circuit (7) is inserted in a manner such that it is vertically sensitive with respect to the axial direction of the coil, characterised in that a common coil former (9) is provided for both half-coils (1, 2), which coil former has between the half-coils a pocket (13) for receiving the integrated Hall circuit (7).

2. Current sensor according to claim 1,
characterised in that there are provided two identical half-coils (1, 2) wound on a respective coil former, which half-coils, on the ends which face away from the integrated Hall circuit (7), are provided with a return iron.

3. Current sensor according to claim 1 or 2,
characterised in that the coil former (9) has three rectangular flanges (10, 11, 12), and the pocket (13) is provided in the centre flange (12), and in that the coil connections (5, 6) are led out on the side which faces away from the pocket opening.

4. Current sensor according to claim 3,
characterised in that the pocket opening is closed off with a printed-circuit board (14) having a protective circuit, to which printed-circuit board are connected the connections (8) for the integrated Hall circuit (7).

5. Current sensor according to claims 3 and 4,
characterised in that the connections (8) for the integrated Hall circuit (7) are provided on the one outer flange (11) and the connections (5, 6) for the half-coils (1, 2) are provided on the other outer flange (10).

6. Current sensor according to one of the preceding claims, characterised in that the current sensor is part of a circuit-breaker (18).

7. Current sensor according to one of the preceding claims, characterised in that three current sensors are brought together as a unit with a housing (17) for fastening to a circuit-breaker (18).

8. Current sensor according to one of the preceding claims, characterised in that the current sensor is connected by way of an interface module (21, 22) and a primary bus system to a computer system.

## Revendications

1. Capteur de courant comportant un circuit intégré (7) à effet Hall, qui peut être influencé par une bobine, qui est formée de deux demi-bobines se trouvant l'une derrière l'autre dans la direction de l'axe de la bobine et reliées entre elles et dans laquelle passe du courant, le circuit (7) intégré à effet Hall étant inséré en étant sensible verticalement par rapport à la direction de l'axe de la bobine entre les demi-bobines (1, 2), caractérisé en ce qu'il est prévu un corps commun (9) de bobine pour les deux demi-bobines (1, 2), qui comporte une poche (13) pour la réception du circuit intégré (7) à effet Hall entre les demi-bobines.

2. Capteur de courant suivant la revendication 1, caractérisé en ce qu'il est prévu deux demi-bobines (1, 2) identiques chacune enroulée sur un corps de bobine et munies à leurs extrémités éloignées du circuit intégré (7) à effet Hall d'un fer de retour.

3. Capteur de courant suivant la revendication 1 ou 2, caractérisé en ce que le corps (9) de bobine comporte trois brides (10, 11, 12) rectangulaires, la poche (13) est prévue dans la bride médiane (12) et les bornes (5, 6) de la bobine sortent du côté éloigné de l'ouverture de la poche.

4. Capteur de courant suivant la revendication 3, caractérisé en ce que l'ouverture de la poche est fermée par une carte (14) à circuit imprimé à câblage, auquel les bornes (8) pour le circuit intégré (7) à effet Hall sont connectées.

5. Capteur de courant suivant la revendication 3 ou 4, caractérisé en ce que les bornes (8) pour le circuit intégré (7) à effet Hall sont prévues sur l'une (11) des brides extérieures et les bornes (5, 6) pour les demi-bobines (1, 2) sont prévues sur l'autre bride (10) extérieure.

6. Capteur de courant suivant l'une des revendications précédentes, caractérisé en ce que le capteur de courant fait partie d'un disjoncteur (18) de puissance.

7. Capteur de courant suivant l'une des revendications précédentes, caractérisé en ce que trois capteurs de courant sont rassemblés en une unité comportant un boîtier (17) à joindre à un disjoncteur (18) de puissance.

8. Capteur de courant suivant l'une des revendications précédentes, caractérisé en ce que le capteur de courant est en liaison avec un système informatique par l'intermédiaire d'un élément (21, 22) d'adaptation et d'un système de bus de rang hiérarchique supérieur.
